# EUROPEAN PATENT APPLICATION

(11) **EP 3 506 346 A2**
(43) Date of publication of application: **03.07.2019**
(21) Application number: 18209342.7
(22) Date of filing: 29.11.2018
(51) Int. Cl.: H01L 23/485, H01L 21/60, H01L 21/48

(54) **SUBSTRATE ASSEMBLY WITH SPACER ELEMENT**

(30) Priority: 29.12.2017 US 201715859313
(71) Applicant: INTEL Corporation, Santa Clara, CA 95054 (US)
(72) Inventor: XIE, Huxiao, Phoenix, AZ Arizona 85048 (US); EITAN, Amram, Scottsdale, AZ Arizona 85258 (US); LU, Xiao, Chandler, AZ Arizona 85226 (US)
(74) Representative: 2SPL Patentanwälte PartG mbB

(57) **Abstract**

Apparatuses, systems, and methods associated with spacer elements for maintaining a distance between a substrate and component during reflow are disclosed herein. In embodiments, a substrate assembly may include a substrate and a component. The component may be coupled to the substrate via a solder joint, wherein the solder joint may include a spacer element and solder, the spacer element to maintain a distance between the substrate and the component. Other embodiments may be described and/or claimed.

## Description

### Technical Field

The present disclosure relates to the field of electronic circuits. More particularly, the present disclosure relates to spacer elements for maintaining a distance between a substrate and component during reflow.

### Background

The background description provided herein is for the purpose of generally presenting the context of the disclosure. Unless otherwise indicated herein, the materials described in this section are not prior art to the claims in this application and are not admitted to be prior art by inclusion in this section.

Legacy procedures of reflowing solder between components and substrates do not implement measures for maintaining distance between the components and substrates during the reflowing process. As the solder is reflowed, the solder may collapse allowing the components to sink toward the substrates and reducing the distance between the components and the substrates. The reduced distance between the components and the substrates may lead to poor solder fatigue life and poor epoxy flow underneath the components, which may cause reliability concerns when enabling epoxy encapsulation. Further, solder balls may become trapped between the components and the substrates during the reflowing process, where the solder balls may be difficult to remove when the components and substrates are close together.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
Figure 1 illustrates an example substrate assembly, according to various embodiments.
Figure 2 illustrates example procedures for forming substrate assemblies, according to various embodiments.
Figure 3 illustrates an example substrate in accordance with stages 202 and 204.
Figure 4 illustrates an example substrate in accordance with stages 206 and 208.
Figure 5 illustrates the example substrate of Figure 4 in accordance with stages 210 and 212.
Figure 6 illustrates an example substrate in accordance with stages 214 and 216.
Figure 7 illustrates the example substrate of Figure 6 in accordance with stages 218 and 220.
Figure 8 illustrates a substrate arrangement in accordance with stage 222.
Figure 9 illustrates a resultant substrate assembly in accordance with stage 224.
Figure 10 illustrates another example substrate assembly, according to various embodiments.
Figure 11 illustrates example procedures for forming substrate assemblies, according to various embodiments.
Figure 12 illustrates an example substrate in accordance with stage 1102.
Figure 13 illustrates an example substrate in accordance with stages 1104 and 1106.
Figure 14 illustrates an example substrate in accordance with stages 1108, 1110, and 1112.
Figure 15 illustrates an example substrate in accordance with stages 1116 and 1118.
Figure 16 illustrates an example substrate arrangement in accordance with stage 1120.
Figure 17 illustrates a resultant substrate assembly in accordance with stage 1122.
Figure 18 illustrates an example computer device that may employ the apparatuses and/or methods described herein.

### Detailed Description

Apparatuses, systems, and methods associated with spacer elements for maintaining a distance between a substrate and component during reflow are disclosed herein. In embodiments, a substrate assembly may include a substrate and a component. The component may be coupled to the substrate via a solder joint, wherein the solder joint may include a spacer element and solder, the spacer element to maintain a distance between the substrate and the component.

In the following detailed description, reference is made to the accompanying drawings which form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

Aspects of the disclosure are disclosed in the accompanying description. Alternate embodiments of the present disclosure and their equivalents may be devised without parting from the spirit or scope of the present disclosure. It should be noted that like elements disclosed below are indicated by like reference numbers in the drawings.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

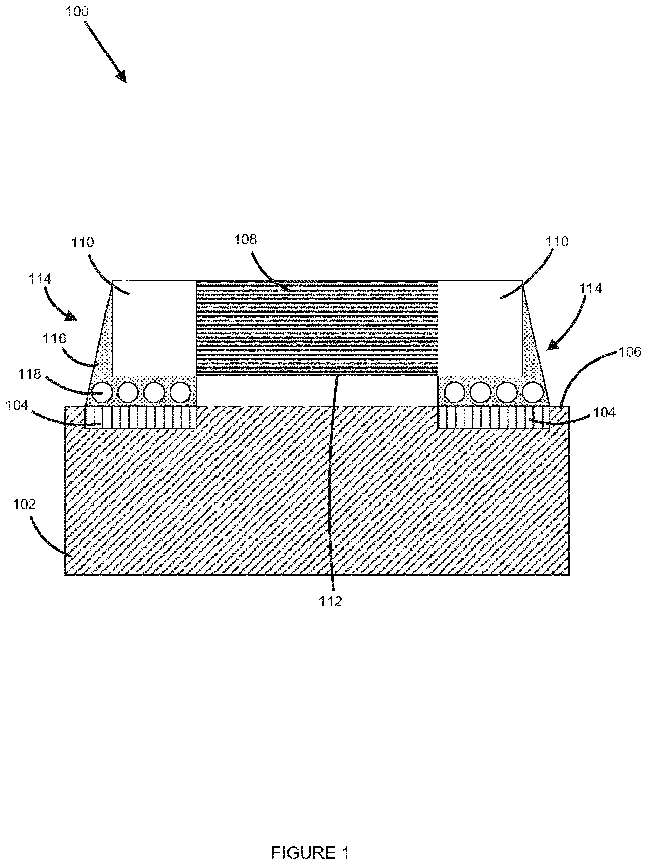

Figure 1 illustrates an example substrate assembly 100, according to various embodiments. The substrate assembly 100 may include a substrate 102. The substrate 102 may comprise any substrate known to one having ordinary skill in the art. In particular, the substrate 102 may include a dielectric material with one or more conductive elements located within the dielectric material, the conductive elements utilized for conducting signals through the substrate 102.

The substrate 102 may further include one or more pads 104 located at a surface 106 of the substrate 102. The pads 104 may be coupled to one or more of the conductive elements within the substrate 102 and may allow signals to pass between the pads 104 and the conductive elements to which the pads 104 are coupled.

The substrate assembly 100 may further include a component 108 located adjacent to the surface 106. The component 108 may comprise any electrical component, including, but not limited to, a processor, a resistor, a capacitor, a transistor, a memory device, or some combination thereof. The component 108 may include one or more pads 110. The pads 110 may be located at, or extend to, a surface 112 of the component 108, wherein the surface 112 may be directed toward the substrate 102. The pads 110 may be coupled to one or more elements within the component 108 (such as a die) and may allow signals to pass between the pads 110 and the elements.

The substrate assembly 100 may further include one or more solder joints 114 that couple the pads 104 of the substrate 102 to the pads 110 of the component 108. The solder joints 114 may include solder 116 and one or more spacer elements 118. The solder 116 may comprise lead-based solder, lead-free solder, silver alloy solder, or some combination thereof. In particular, the solder 116 may include tin, silver, copper, lead, hydrogen, oxygen, nitrogen, or some combination thereof.

The spacer elements 118 may include one or more balls, or other shaped elements, that are interspersed within the solder 116. The spacer elements 118 may comprise a material with a higher melting point than the solder 116. For example, the solder 116 may comprise a material that has a melting point between 170 degrees Celsius and 270 degrees Celsius, while the spacer elements 118 may comprise a material that has a melting point higher than 270 degrees Celsius. In some embodiments, the solder 116 may comprise a material that has a melting point of 225 degrees Celsius, while the spacer elements 118 comprise a material that has a melting point higher than 225 degrees Celsius. Further, the spacer elements 118 may comprise any metal that has a melting point higher than a melting point of the solder 116, which may include nickel, copper, or some combination thereof. In some embodiments, the spacer elements 118 may further include a metal coating, such as a tin coating.

The spacer elements 118 may maintain at least a desired minimum distance between the component 108 and the substrate 102 during a reflow process. Accordingly, the spacer elements 118 may have a diameter, length, width, and/or height equal to the desired minimum distance. For example, in embodiments where the spacer elements 118 are balls, the balls may have a diameter equal to the desired minimum distance. In some embodiments, the diameter, length, width, and/or height of the spacer elements 118 may be between 10 microns and 50 microns. In other embodiments, the diameter, length, width, and/or height of the spacer elements 118 may be greater than 10 microns.

In other embodiments, the spacer elements 118 may have a diameter, length, width, and/or height less than the desired minimum distance between the component 108 and the substrate 102. In these embodiments, a density of the spacer elements 118 within the solder joints 114 may be selected to allow the spacer elements 118 to maintain at least the desired minimum distance between the component 108 and the substrate 102 during the reflow process. In particular, the density may be selected to be high enough that the spacer elements 118 maintain at least the desired minimum distance between the component 108 and the substrate 102 when the spacer elements 118 settle within the area defined by the solder joints 114.

The spacer elements 118 maintaining at least the desired minimum distance between the component 108 and the substrate 102 may provide better solder fatigue life and better epoxy flow underneath the component 108 than if the distance between the component 108 and the substrate 102 is less than the desired minimum distance. Further, the spacer elements 118 maintaining the desired minimum distance may provide enough space between the component 108 and the substrate 102 to clean out any solder bridges or solder balls that may be incidentally formed between the component 108 and the substrate 102 during the reflow process.

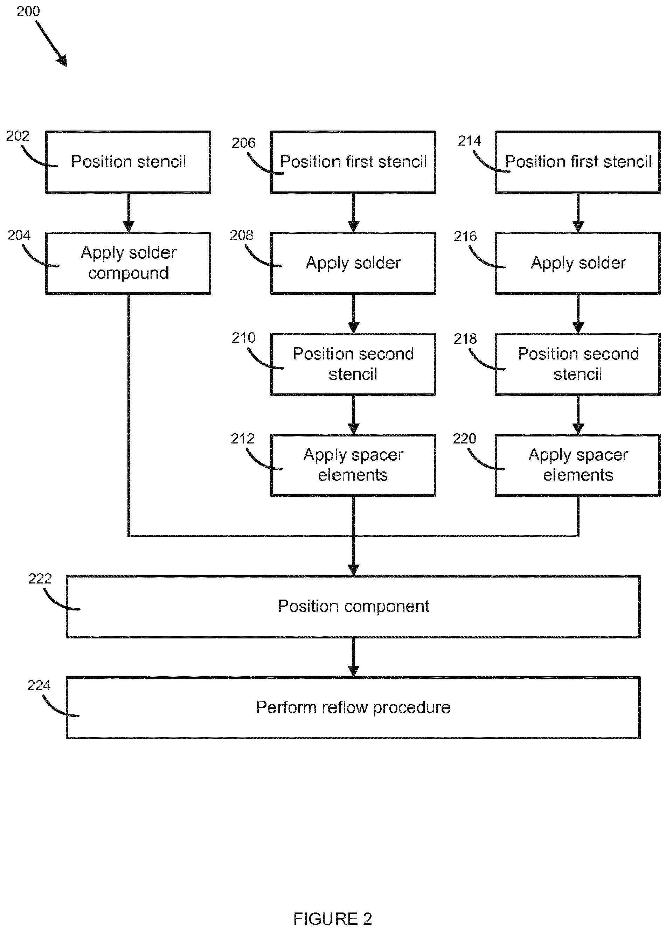

Figure 2 illustrates example procedures 200 for forming substrate assemblies, according to various embodiments. In particular, Figure 2 illustrates three procedures for forming substrate assemblies according to various embodiments, wherein each of the procedures may include some common stages and some stages that may be performed in the alternative. The first procedure may include stages 202, 204, 222, and 224; the second procedure may include stages 206, 208, 210, 212, 222, and 224, and the third procedure may include stages 214, 216, 218, 220, 222, and 224.

In stage 202, a stencil may be positioned on a surface of a substrate, such as the substrate 102 (Fig. 1). The stencil may have one or more openings, wherein the openings are to leave a portion of the substrate exposed when the stencil is positioned on the surface of the substrate. The stencil may be positioned with the openings located adjacent to pads (such as the pads 104 (Fig. 1)) of the substrate. The procedure may proceed to stage 204.

In stage 204, a solder compound may be applied to the surface of the substrate. In particular, the solder compound may be applied to the surface of the substrate while the stencil of stage 202 is still positioned on the surface of the substrate, wherein the solder compound is applied to the portion of the surface exposed by the openings of the stencil. The surface exposed by the openings of the stencil may include the pads of the substrate, which may result in the solder compound being applied to the pads of the substrate. The solder compound may fill, or partially fill, the openings of the stencil when applied to the surface. The procedure may proceed to stage 222.

The solder compound may include solder (such as the solder 116 (Fig. 1)) and one or more spacer elements (such as the spacer elements 118 (Fig. 1)), which may have been combined prior to the application of the solder compound to the surface of the substrate. In particular, the spacer elements may be interspersed within the solder prior to the application of the solder compound. The solder may comprise a solder paste, wherein the solder paste may maintain positions of the solder and the spacer elements when the solder compound is applied to the surface of the substrate. The stencil may be removed after the solder compound has been applied to the surface of the substrate.

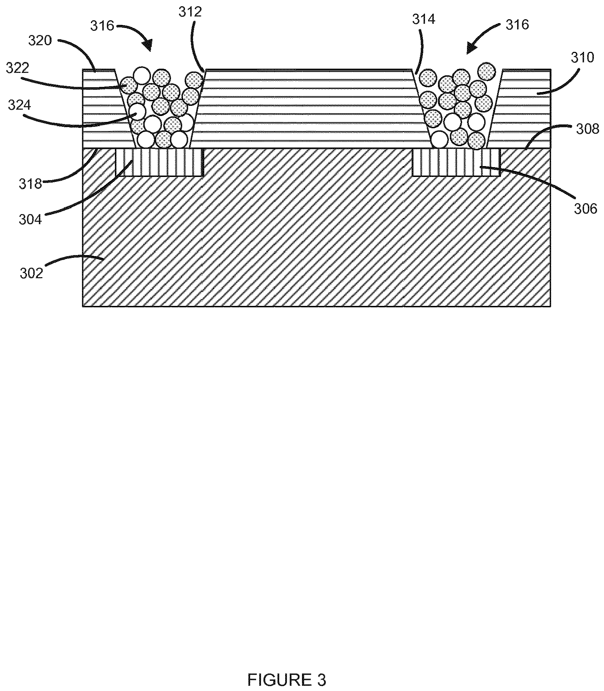

Figure 3 illustrates an example substrate 302 in accordance with stages 202 and 204. The substrate 302 may include one or more of the features of the substrate 102 (Fig. 1). The substrate 302 may include a first pad 304 and a second pad 306 located at a surface 308 of the substrate 302. The first pad 304 and the second pad 306 each may include one or more of the features of the pads 104 (Fig. 1).

A stencil 310 may be positioned on the surface 308 of the substrate 302. The stencil 310 may have a first opening 312 and a second opening 314. The first opening 312 may be positioned adjacent to the first pad 304 and may leave a portion of the first pad 304 exposed when the stencil 310 is positioned on the surface 308. Further, the second opening 314 may be positioned adjacent to the second pad 306 and may leave a portion of the second pad 306 exposed when the stencil 310 is positioned on the surface 308. The first opening 312 and the second opening 314 of the stencil 310 may form recesses having a depth equal to a thickness of the stencil 310. The thickness of the stencil 310 and/or size of the first opening 312 and the second opening 314 may be selected to form recesses of a size to contain a predetermined amount of solder compound 316 to maintain a distance between the substrate 302 and a component to be mounted to the substrate. Further, the thickness of the stencil 310 may be selected to be greater than a desired minimum distance between the substrate 302 and the component to compensate for any settling that may occur during a reflow process.

Solder compound 316 may be applied to the surface 308 exposed by the first opening 312 and the second opening 314. In particular, the solder compound 316 may be applied on a portion of the first pad 304 exposed by the first opening 312 and on a portion of the second pad 306 exposed by the second opening 314. The solder compound 316 may fill, or partially fill, the recesses formed by the first opening 312 and the second opening 314. For example, the solder compound 316 may extend from a first side 318 of the stencil 310, located against the substrate 302, to a second side 320 of the stencil 310, located at an opposite side of the stencil 310 from the substrate 302, in both the first opening 312 and the second opening 314.

The solder compound 316 may include solder 322 and spacer elements 324. The spacer elements 324 may be interspersed within the solder 322. The solder 322 may comprise solder paste, which may maintain positions of the solder 322 and the spacer elements 324 after the solder compound 316 has been applied. The spacer elements 324 may include one or more of the features of the spacer elements 118 (Fig. 1). Although the solder 322 and the spacer elements 324 are represented as a plurality of circles, it is to be understood that the circles are merely a representation and the solder 322 and the spacer elements 324 may be any shape and/or form described herein. The stencil 310 may be removed after the solder compound 316 has been applied, wherein the solder 322 may maintain the positions of solder 322 and the spacer elements 324 after the stencil 310 has been removed.

In stage 206, a first stencil may be positioned on a surface of a substrate, such as the substrate 102 (Fig. 1). The first stencil may have one or more openings, wherein the openings are to leave a portion of the substrate exposed when the first stencil is positioned on the surface of the substrate. The first stencil may be positioned with the openings located adjacent to pads (such as the pads 104 (Fig. 1)) of the substrate. The procedure may proceed to stage 208.

In stage 208, solder may be applied to the surface of the substrate. In particular, the solder may be applied to the surface of the substrate while the first stencil of stage 206 is still positioned on the surface of the substrate, wherein the solder is applied to the portion of the surface exposed by the openings of the first stencil. The surface exposed by the openings of the first stencil may include the pads of the substrate, which may result in the solder being applied to the pads of the substrate. The solder may fill, or partially fill, the openings of the first stencil when applied to the surface. The solder may be reflowed (heat treated) prior to stage 210. The solder may be electrical/electroless plated or vapor deposited in other embodiments. The procedure may proceed to stage 210.

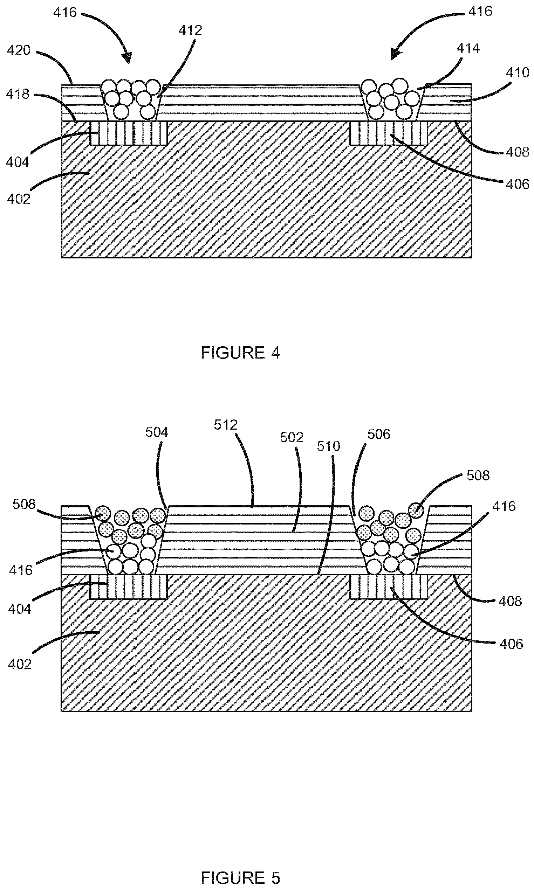

Figure 4 illustrates an example substrate 402 in accordance with stages 206 and 208. The substrate 402 may include one or more of the features of the substrate 102 (Fig. 1). The substrate 402 may include a first pad 404 and a second pad 406 located at a surface 408 of the substrate 402. The first pad 404 and the second pad 406 each may include one or more of the features of the pads 104 (Fig. 1).

A first stencil 410 may be positioned on the surface 408 of the substrate 402. The first stencil 410 may have a first opening 412 and a second opening 414. The first opening 412 may be positioned adjacent to the first pad 404 and may leave a portion of the first pad 404 exposed when the first stencil 410 is positioned on the surface 408. Further, the second opening 414 may be positioned adjacent to the second pad 406 and may leave a portion of the second pad 406 exposed when the first stencil 410 is positioned on the surface 408. The first opening 412 and the second opening 414 of the first stencil 410 may form recesses having a depth equal to a thickness of the first stencil 410. The thickness of the first stencil 410 and/or size of the first opening 412 and the second opening 414 may be selected to form recesses of a size to contain a predetermined amount of solder 416 to be utilized to form a solder joint (such as solder joints 114 (Fig. 1)).

The solder 416 may be applied to the surface 408 exposed by the first opening 412 and the second opening 414. In particular, the solder 416 may be applied on a portion of the first pad 404 exposed by the first opening 412 and on a portion of the second pad 406 exposed by the second opening 414. The solder 416 may fill, or partially fill, the recesses formed by the first opening 412 and the second opening 414. For example, the solder 416 may extend from a first side 418 of the first stencil 410, located against the substrate 402, to a second side 420 of the first stencil 410, located at an opposite side of the first stencil 410 from the substrate 402, in both the first opening 412 and the second opening 414.

The solder 416 may comprise solder paste, which may maintain the position of the solder 416 after the solder 416 has been applied. Although the solder 416 is represented as a plurality of circles, it is to be understood that the circles are merely a representation and the solder 416 may be any shape and/or form described herein.

The first stencil 410 may be removed after the solder 416 has been applied, wherein the solder 416 may maintain the position of the solder 416 after the first stencil 410 has been removed. In other embodiments, the first stencil 410 may be left on the surface 408 of the substrate 402 after the solder 416 has been applied. In these embodiments, another stencil may be positioned on the second side 420 of the first stencil 410 in stage 210, as described further below in relation to stage 210.

In some embodiments, the solder 416 may be reflowed (heat treated) prior to stage 210. The solder 416 may be electrical/electroless plated or vapor deposited in some embodiments.

In stage 210, a second stencil may be positioned on the surface of the substrate. The second stencil may be thicker than the first stencil utilized in stage 206. The second stencil may have one or more openings, wherein the openings are to leave a portion of the substrate exposed when the second stencil is positioned on the surface of the substrate. The second stencil may be positioned with the openings located adjacent to the pads of the substrate. Further, the second stencil may be positioned with the solder applied in stage 208 located within the openings.

In other embodiments where the first stencil is not removed after the solder is applied in stage 208, the second stencil may be positioned on a surface of the first stencil opposite from the substrate. The one or more openings of the second stencil may align with the openings of the first stencil. Further, the openings of the second stencil may be located adjacent to the solder applied in stage 208. The procedure may proceed to stage 212.

In stage 212, one or more spacer elements may be applied on the surface of the substrate. In particular, the spacer elements may be applied while the second stencil of stage 210 is still positioned on the surface of the substrate, wherein the spacer elements may be applied within the openings of the second stencil. The openings may expose the solder applied in stage 208 and the spacer elements may be applied on top of the solder. The spacer elements may remain on top of the solder or may at least partially intersperse within the solder when applied on top of the solder. The spacer elements may fill, or partially fill, the openings of the second stencil when applied on the surface. The solder may maintain the positions of the solder and the spacer elements after spacer elements are applied. The second stencil and/or the first stencil may be removed after the spacer elements are applied. The procedure may proceed to stage 222.

Figure 5 illustrates the example substrate 402 of Figure 4 in accordance with stages 210 and 212. A second stencil 502 may be positioned on the surface 408 of the substrate 402. The second stencil 502 may have a first opening 504 and a second opening 506. The first opening 504 may be positioned adjacent to the first pad 404 and may leave a portion of the first pad 404 and/or the solder 416 located on the first pad 404 exposed when the second stencil 502 is positioned on the surface 408. Further, the second opening 506 may be positioned adjacent to the second pad 406 and may leave a portion of the second pad 406 and/or the solder 416 located on the second pad 406 exposed when the second stencil 502 is positioned on the surface 408. The first opening 504 and the second opening 506 of the second stencil 502 may form recesses having a depth equal to a thickness of the second stencil 502. The thickness of the stencil 502 and/or the size of the first opening 504 and the second opening 506 may be selected to form recesses of a size to contain a predetermined amount of solder 416 and spacer elements 508 to maintain a distance between the substrate 402 and a component to be mounted to the substrate 402. Further, the thickness of the stencil 502 may be selected to be greater than a desired minimum distance between the substrate 402 and the component to compensate for any settling that may occur during a reflow process.

The spacer elements 508 may be applied on the surface 408 exposed by the first opening 504 and the second opening 506. In particular, the spacer elements 508 may be applied on the solder 416 located within the first opening 504 and the second opening 506. The spacer elements 508 may remain on top of the solder 416, or may intersperse within the solder 416, while being applied on the solder 416. The spacer elements 508 and the solder 416 may fill, or partially fill, the recesses formed by the first opening 504 and the second opening 506. For example, the spacer elements 508 and the solder 416 may extend from a first side 510 of the second stencil 502, located against the substrate 402, to a second side 512 of the second stencil 502, located at an opposite side of the second stencil 502 from the substrate, in both the first opening 504 and the second opening 506.

The spacer elements 508 may include one or more of the features of the spacer elements 118 (Fig. 1). Although the spacer elements 508 are represented as a plurality of circles, it is to be understood that the circles are merely a representation and the spacer elements 508 may be any shape and/or form described herein. The solder 416 may maintain the positions of the solder 416 and the spacer elements 508 after the spacer elements 508 have been applied. The second stencil 502 may be removed after the spacer elements 508 have been applied, wherein the solder 416 may maintain the positions of the solder 416 and the spacer elements 508 after the second stencil 502 has been removed.

In embodiments where the first stencil 410 (Fig. 4) is left on the surface 408 of the substrate 402 after the solder 416 is applied in stage 208 and a second stencil is positioned on the second side 420 (Fig. 4) of the first stencil 410, the first stencil 410 and the second stencil positioned on the first stencil 410 may include one or more of the features of the second stencil 502 shown in the illustrated embodiment. In particular, the first stencil 410 and the second stencil positioned on the first stencil 410 may have openings that form the first opening 504 and the second opening 506 shown in the illustrated embodiment. In these embodiments, the first stencil 410 and the second stencil positioned on the first stencil 410 may be removed after the spacer elements 508 have been applied.

In stage 214, a first stencil may be positioned on a surface of a substrate, such as the substrate 102 (Fig. 1). The first stencil may have one or more openings, wherein the openings are to leave a portion of the substrate exposed when the first stencil is positioned on the surface of the substrate. The first stencil may be positioned with the openings located adjacent to pads (such as the pads 104 (Fig. 1)) of the substrate. The procedure may proceed to stage 216.

In stage 216, solder may be applied to the surface of the substrate. In particular, the solder may be applied to the surface of the substrate while the first stencil of stage 214 is still positioned on the surface of the substrate, wherein the solder is applied to the portion of the surface exposed by the openings of the first stencil. The surface exposed by the openings of the first stencil may include the pads of the substrate, which may result in the solder being applied to the pads of the substrate. The solder may fill, or partially fill, the openings of the first stencil when applied to the surface. The procedure may proceed to stage 210.

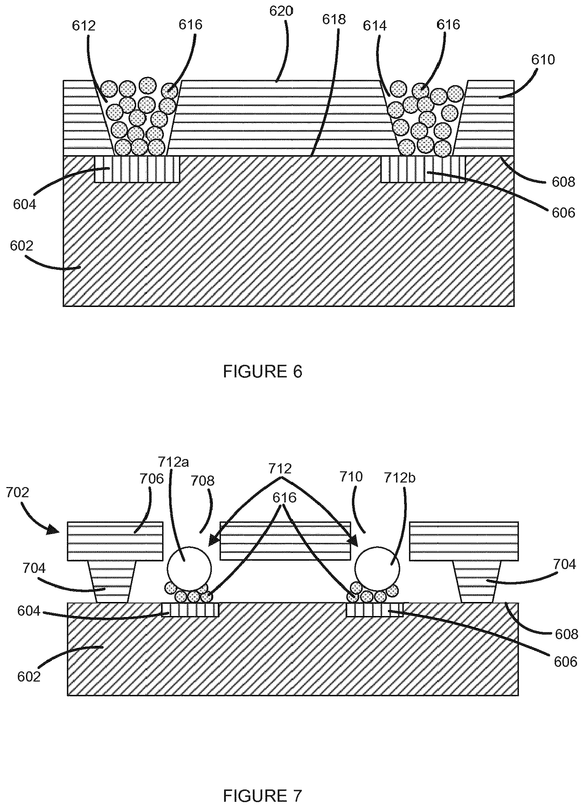

Figure 6 illustrates an example substrate 602 in accordance with stages 214 and 216. The substrate 602 may include one or more of the features of the substrate 102 (Fig. 1). The substrate 602 may include a first pad 604 and a second pad 606 located at a surface 608 of the substrate 602. The first pad 604 and the second pad 606 each may include one or more of the features of the pads 104 (Fig. 1).

A first stencil 610 may be positioned on the surface 608 of the substrate 602. The first stencil 610 may have a first opening 612 and a second opening 614. The first opening 612 may be positioned adjacent to the first pad 604 and may leave a portion of the first pad 604 exposed when the first stencil 610 is positioned on the surface 608. Further, the second opening 614 may be positioned adjacent to the second pad 606 and may leave a portion of the second pad 606 exposed when the first stencil 610 is positioned on the surface 608. The first opening 612 and the second opening 614 of the first stencil 610 may form recesses having a depth equal to a thickness of the first stencil 610. The thickness of the first stencil 610 and/or size of the first opening 612 and the second opening 614 may be selected to form recesses of a size to contain a predetermined amount of solder 616 to be utilized to form a solder joint (such as solder joints 114 (Fig. 1)).

The solder 616 may be applied to the surface 608 exposed by the first opening 612 and the second opening 614. In particular, the solder 616 may be applied on a portion of the first pad 604 exposed by the first opening 612 and on a portion of the second pad 606 exposed by the second opening 614. The solder 616 may fill, or partially fill, the recesses formed by the first opening 612 and the second opening 614. For example, the solder 616 may extend from a first side 618 of the first stencil 610, located against the substrate 602, to a second side 620 of the first stencil 610, located at an opposite side of the first stencil 610 from the substrate 602, in both the first opening 612 and the second opening 614.

The solder 616 may comprise solder paste, which may maintain the position of the solder 616 after the solder 616 has been applied. Although the solder 616 is represented as a plurality of circles, it is to be understood that the circles are merely a representation and the solder 616 may be any shape and/or form described herein. The first stencil 610 may be removed after the solder 616 has been applied, wherein the solder 616 may maintain the position of the solder 616 after the first stencil 610 has been removed.

In stage 218, a second stencil may be positioned on the surface of the substrate. The second stencil may include one or more supports that may contact the surface of the substrate and may support a body of the stencil at a certain distance off of the substrate. The second stencil may have one or more openings, wherein the openings are to be located over the solder applied in stage 216. The openings may further be located over the pads of the substrate on which the solder was applied in stage 216.

In stage 220, one or more spacer elements may be applied on the surface of the substrate. In particular, the spacer elements may be applied while the second stencil of stage 218 is still positioned on the surface of the substrate, wherein the spacer elements may be applied within the openings of the second stencil. One spacer element may be applied in each of the openings, wherein each of the spacer elements may have a diameter, width, length, and/or height equal to a desired minimum distance that a component is to be located from the substrate when mounted to the substrate. The openings may expose the solder applied in stage 216 and the spacer elements may be applied on top of the solder. The spacer elements may remain on top of the solder or may sink into the solder when applied on top of the solder. The solder may maintain the positions of the solder and the spacer elements after spacer elements are applied. The second stencil may be removed after the spacer elements are applied. The procedure may proceed to stage 222.

Figure 7 illustrates the example substrate 602 of Figure 6 in accordance with stages 218 and 220. A second stencil 702 may be positioned on the surface 608 of the substrate 602. In particular, supports 704 of the second stencil 702 may contact the surface 608 of the substrate 608 and maintain a body 706 of the stencil 702 at a certain distance off of the surface 608 of the substrate 602. In some embodiments, the body 706 of the stencil 702 may be maintained off of the surface 608 of the substrate 602 by at least half of the desired minimum distance to be maintained between the substrate 602 and a component to be coupled to the substrate 602. The body 706 of the second stencil 702 may have a first opening 708 and a second opening 710. The first opening 708 may be positioned adjacent to the first pad 604 and the solder 616 located on the first pad 604 exposed when the second stencil 702 is positioned on the surface 608. Further, the second opening 710 may be positioned adjacent to the second pad 606 and the solder 616 located on the second pad 606 exposed when the second stencil 702 is positioned on the surface 608.

Spacer elements 712 may be applied on the surface 608 of the substrate 602 adjacent to the first opening 708 and the second opening 710. In particular, a first spacer element 712a may be applied on the solder 616 located adjacent to the first opening 708 and a second spacer element 712b may applied on the solder 616 located adjacent to the second opening 710. The spacer elements 712 may remain on top of the solder 616, or may sink into the solder 616, while being applied on the solder 616.

The spacer elements 712 may include one or more of the features of the spacer elements 118 (Fig. 1). Although each of the spacer elements 712 are represented as a circle, it is to be understood that the circles are merely a representation and the spacer elements 712 may be any shape and/or form described herein. The solder 616 may maintain the positions of the solder 616 and the spacer elements 712 after the spacer elements 712 have been applied. The second stencil 702 may be removed after the spacer elements 712 have been applied, wherein the solder 616 may maintain the positions of the solder 616 and the spacer elements 712 after the second stencil 702 has been removed.

In stage 222, a component (such as the component 108 (Fig. 1)) may be positioned on the substrate. In particular, the component may be positioned on a surface of the substrate with pads (such as the pads 110 (Fig. 1)) of the substrate located on the solder compound, the solder, the spacer elements, or some combination thereof. For example, the pads may be located on the solder compound applied in stage 204, on the solder applied in stage 208 and/or the spacer elements applied in stage 212, or on the solder applied in stage 216 and the solder elements applied in stage 220. The procedure may proceed to stage 224.

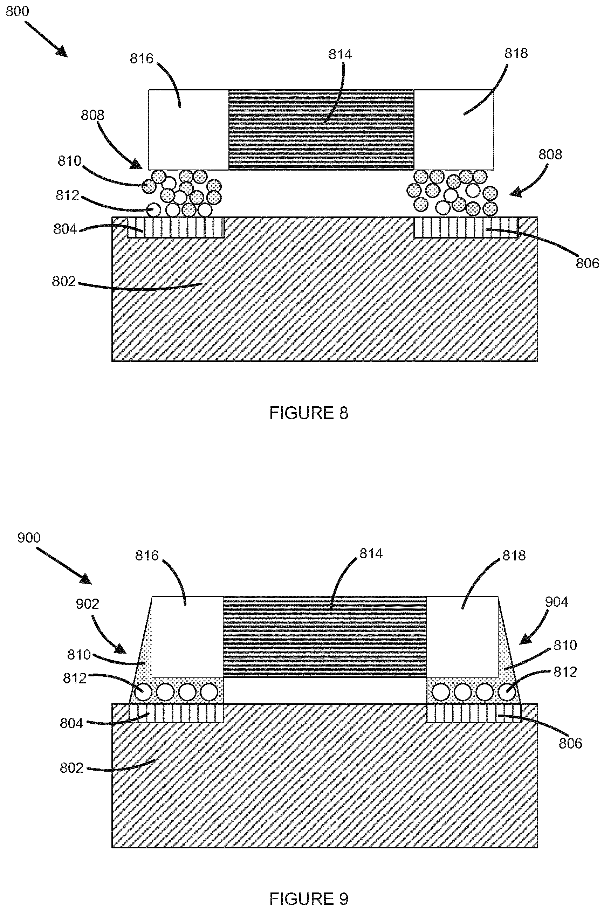

Figure 8 illustrates a substrate arrangement 800 in accordance with stage 222. The substrate arrangement 800 may include a substrate 802. The substrate 802 may include one or more of the features of the substrate 102 (Fig. 1). The substrate 802 may include a first pad 804 and a second pad 806. Solder compound 808 may be located on both the first pad 804 and the second pad 806. In particular, the solder compound 808 may have been applied to the first pad 804 and the second pad 806 in stages 202 and 204, in stages 206, 208, 210, and 212, or in stages 214, 216, 218, and 220. The solder compound 808 may include solder 810 and spacer elements 812. The solder 810 may include one or more of the features of the solder 116 (Fig. 1). Further, the spacer elements 812 may include one or more of the features of the spacer elements 118 (Fig. 1). The illustrated embodiment shows multiple spacer elements 812 interspersed within the solder 810, in accordance with the results of stage 204 and stage 212. However, it is to be understood that the same arrangement may be produced with one spacer element located on each of the first pad 804 and the second pad 806 with solder, in accordance with the results of stage 220.

The substrate arrangement 800 may include a component 814 positioned on the substrate 802. The component 814 may include one or more of the features of the component 108 (Fig. 1). The component 814 may include a first pad 816 and a second pad 818. The first pad 816 may be positioned on the solder compound 808 that is located on the first pad 804 of the substrate 802 and the second pad 818 may be positioned on the solder compound 808 located on the second pad 806 of the substrate 802.

In stage 224, a reflow process may be performed on the substrate arrangement formed in stage 222. The reflow process may comprise heating the substrate arrangement to a temperature above the melting point of the solder, but below the melting point of the spacer elements. For example, in embodiments where the solder has a melting point between 170 degrees Celsius and 270 degrees Celsius and the spacer elements have a melting point greater than 270 degrees Celsius, the substrate arrangement may be heated to a temperature between 170 degrees and 270 degrees Celsius to cause the solder to melt. Further, in embodiments where the solder has a melting point of 225 degrees Celsius, the substrate arrangement may be heated to a temperature higher than 225 degrees Celsius, but less than a melting point of the spacer elements. After heating the substrate arrangement, the solder may be cooled, or may be allowed to cool, causing the solder to solidify.

Figure 9 illustrates a resultant substrate assembly 900 in accordance with stage 224. The substrate assembly 900 may include the substrate 802 and the component 814. The component 814 may be coupled to the substrate 802 via a first solder joint 902 and a second solder joint 904. In particular, the first solder joint 902 may couple the first pad 816 of the component 814 to the first pad 804 of the substrate 802. Further, the second solder joint 904 may couple the second pad 818 of the component 814 to the second pad 806 of the substrate 802.

The first solder joint 902 and the second solder joint 904 may have been formed by performing the reflow process of stage 224 on the substrate arrangement 800 (Fig. 8). In particular, the reflow process may have caused the solder 810 within the solder compound 808 (Fig. 8) on the first pad 804 to melt and solidify to form the first solder joint 902. Further, the reflow process may have caused the solder 810 within solder compound 808 on the second pad 806 to melt and solidify to form the second solder joint 904. The spacer elements 812 may have remained solid during the reflow process.

The first solder joint 902 may include the solder 810 and the spacer elements 812. The spacer elements 812 may have shifted while the solder 810 was melted, resulting in the spacer elements 812 being arranged along the first pad 804 due to gravity causing the spacer elements 812 to shift downwards toward the first pad 804. The spacer elements 812 may have maintained the desired minimum distance between the component 814 and the substrate 802 during the reflow process since the spacer elements 812 remained solid. The solder 810 may have flowed to contact both the first pad 816 of the component 814 and the first pad 804 of the substrate 802 during the reflow process, and may couple the first pad 816 and the first pad 804 when solidified at the end of the reflow process.

The second solder joint 904 may include the solder 810 and the spacer elements 812. The spacer elements 812 may have shifted while the solder 810 was melted, resulting in the spacer elements 812 being arranged along the second pad 806 due to gravity causing the spacer elements 812 to shift downwards toward the second pad 806. The spacer elements 812 may have maintained the desired minimum distance between the component 814 and the substrate 802 during the reflow process since the spacer elements 812 remained solid. The solder 810 may have flowed to contact both the second pad 818 of the component 814 and the second pad 806 of the substrate 802 during the reflow process, and may couple the second pad 818 and the second pad 806 when solidified at the end of the reflow process.

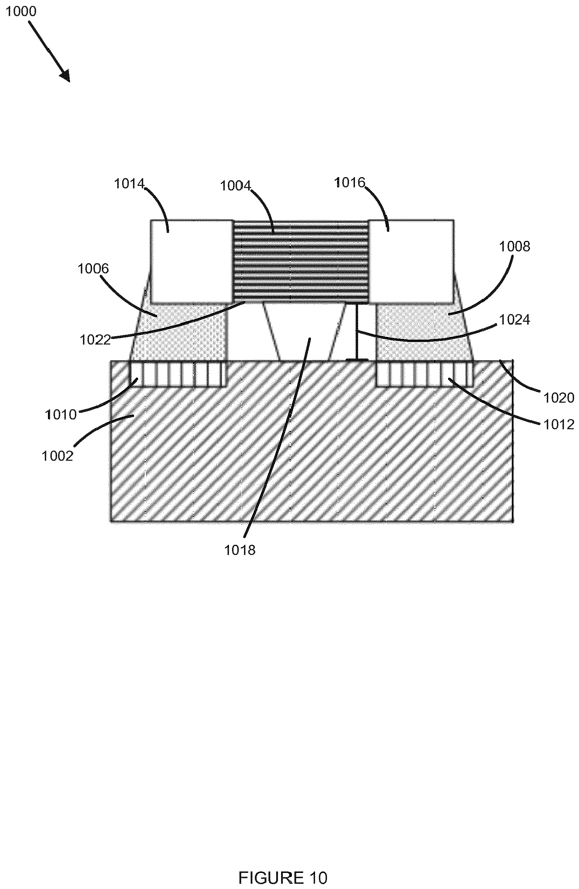

Figure 10 illustrates another example substrate assembly 1000, according to various embodiments. The substrate assembly 1000 may include a substrate 1002. The substrate 1002 may include one or more of the features of the substrate 102 (Fig. 1). The substrate assembly 1000 may further include a component 1004 coupled to the substrate 1002. The component 1004 may include one or more of the features of the component 108 (Fig. 1).

The substrate assembly 1000 may further include a first solder joint 1006 and a second solder joint 1008. The first solder joint 1006 may couple a first pad 1010 of the substrate 1002 to a first pad 1014 of the component 1004. Further, the second solder joint 1008 may couple a second pad 1012 of the substrate 1002 to a second pad 1016 of the component 1004. The first solder joint 1006 and the second solder joint 1008 may both include solder. The solder may comprise lead-based solder, lead-free solder, silver alloy solder, or some combination thereof. In particular, the solder may include tin, silver, copper, lead, hydrogen, oxygen, nitrogen, or some combination thereof.

The substrate assembly 1000 may further include a spacer element 1018. The spacer element 1018 may be located between the substrate 1002 and the component 1004. In particular, the spacer element 1018 may be located on a surface 1020 of the substrate 1002 and may contact a surface 1022 of the component 1004. The spacer element 1018 may be located on the surface 1020 of the substrate 1002 between the first pad 1010 and the second pad 1012. Further, the spacer element 1018 may contact the surface 1022 of the component 1004 between the first pad 1014 and the second pad 1016.

The spacer element 1018 may comprise a polymer material. In some embodiments, the polymer material of the spacer element 1018 may further be a dielectric material. The spacer element 1018 may comprise polyimide, epoxy, benzocyclobutene, or some combination thereof. For example, the spacer element 1018 may include carbon, oxide, nitrogen, hydrogen, or some combination thereof.

The spacer element 1018 may be utilized to maintain at least a desired minimum distance between the substrate 1002 and the component 1004 during a reflow process. For example, the spacer element 1018 may have a height 1024 equal to the desired minimum distance. In some embodiments, the height 1024 of the spacer element 1018 may be between 10 microns and 50 microns. In other embodiments, the height 1024 of the spacer element may be greater than 10 microns.

The spacer element 1018 maintaining at least the desired minimum distance between the substrate 1002 and the component 1004 may provide better solder fatigue life and better epoxy flow underneath the component 1004 than if the distance between the component 1004 and the substrate 1002 is less than the desired minimum distance. Further, the spacer element 1018 maintaining the desired minimum distance may provide enough space between the component 1004 and the substrate 1002 to clean out any solder bridging or solder balls that may be incidentally formed between the component 1004 and the substrate 1002 during the reflow process.

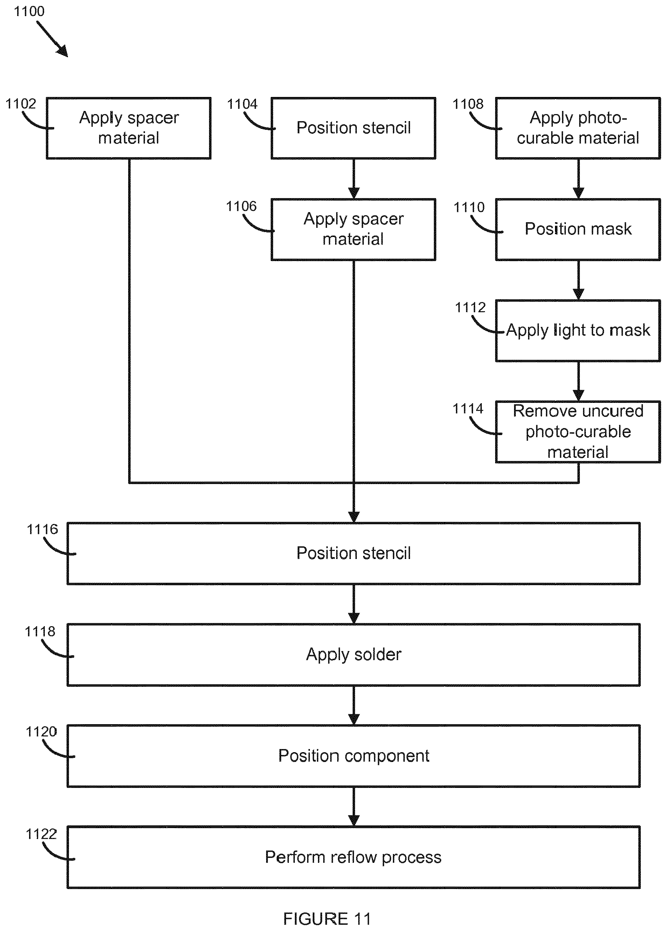

Figure 11 illustrates example procedures 1100 for forming substrate assemblies, according to various embodiments. In particular, Figure 11 illustrates three procedures for forming substrate assemblies according to various embodiments, wherein each of the procedures may include some common stages and some stages that may be performed in the alternative. The first procedure may include stages 1102, 1116, 1118, 1120, and 1122; the second procedure may include stages 1104, 1106, 1116, 1118, 1120, and 1122; and the third procedure may include stages 1108, 1110, 1112, 1114, 1116, 1118, 1120, and 1122.

In stage 1102, spacer material may be applied to a surface of a substrate (such as the substrate 1002 (Fig. 10)). The spacer material may applied on the surface of the substrate via a dispenser or a jetter. The spacer material may be applied on a portion of the surface of the substrate between pads (such as the first pad 1010 (Fig. 10) and/or the second pad 1012 (Fig. 10)) of the substrate to which a component (such as the component 1004 (Fig. 10)) is to be coupled. The spacer material may form a spacer element (such as the spacer element 1018 (Fig. 10)) when cured. The procedure may proceed to stage 1116.

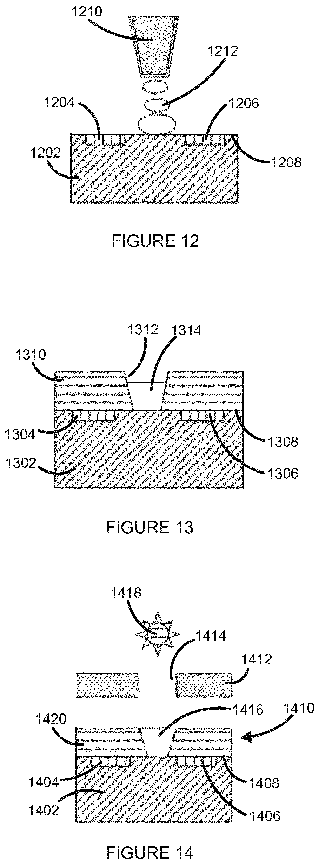

Figure 12 illustrates an example substrate 1202 in accordance with stage 1102. The substrate 1202 may include one or more of the features of the substrate 1002 (Fig. 10). The substrate 1202 may include a first pad 1204 and a second pad 1206 located at a surface 1208 of the substrate 1202.

A dispenser or jetter 1210 may apply a spacer material 1212 to the surface 1208 of the substrate 1202. In particular, the dispenser or jetter 1210 may apply the spacer material 1212 to a portion of the surface 1208 located between the first pad 1204 and the second pad 1206. The spacer material 1212 may form a spacer element (such as the spacer element 1018 (Fig. 10)) when cured.

In stage 1104, a stencil may be positioned on a substrate (such as the substrate 1002 (Fig. 10)). The stencil may have an opening. The opening of the stencil may be positioned adjacent to a portion of the substrate located between pads (such as the first pad 1010 (Fig. 10) and/or the second pad 1012 (Fig. 10)) of the substrate to which a component (such as the component 1004 (Fig. 10)) is to be coupled. The opening of the stencil may leave the portion of the substrate exposed. The procedure may proceed to stage 1106.

In stage 1106, spacer material may be applied to a surface of the substrate. The spacer material may be applied while the stencil of stage 1104 is still positioned on the substrate. The spacer may be applied to the portion of the substrate exposed by the opening of the stencil. In particular, the spacer may be applied to the portion of the substrate located between the pads of the substrate. The procedure may proceed to stage 1116.

Figure 13 illustrates an example substrate 1302 in accordance with stages 1104 and 1106. The substrate 1302 may include one or more of the features of the substrate 1002 (Fig. 10). The substrate 1302 may include a first pad 1304 and a second pad 1306 located at a surface 1308 of the substrate 1302.

A stencil 1310 may be positioned on a surface 1308 of the substrate 1302. The stencil 1310 may have an opening 1312. The opening 1312 may be positioned adjacent to a portion of the substrate 1302 located between the first pad 1304 and the second pad 1306. The opening 1312 of the stencil 1310 may leave the portion of the substrate 1302 exposed. The opening 1312 may form a recess based on a thickness of the stencil 1310.

A spacer material 1314 may be applied to the surface 1308 of the substrate 1302 exposed by the opening 1312 of the stencil 1310. In particular, the spacer material 1314 may be applied to the portion of the surface 1308 located between the first pad 1304 and the second pad 1306. The spacer material 1314 may fill, or partially fill, the recess formed by the opening 1312. The spacer material 1314 may form a spacer element (such as the spacer element 1018 (Fig. 10)) when cured. The stencil 1310 may be removed after the spacer material 1314 has been applied.

In stage 1108, a photo-curable material may be applied to a surface of a substrate (such as the substrate 1002 (Fig. 10)). The photo-curable material may be applied to the entire surface of the substrate. The photo-curable material may include carbon, oxide, nitrogen, hydrogen, or some combination thereof. In some embodiments, the photo-curable material may comprise a dielectric material. The procedure may proceed to stage 1110.

In stage 1110, a mask may be positioned on or over the photo-curable material. The mask may have an opening. The opening may be positioned on or over a portion of the photo-curable material at which a spacer element (such as the spacer element 1018 (Fig. 10)) is to be formed on the surface of the substrate. The opening may be positioned on or over a portion of the photo-curable material that aligns with a portion of the surface of the substrate located between pads (such as the first pad 1010 (Fig. 10) and the second pad 1012 (Fig. 10)) of the substrate to which a component (such as the component 1004 (Fig. 10)) is to be coupled. The procedure may proceed to stage 1112.

In stage 1112, light may be applied to the mask. The opening in the mask may allow a portion of the light to pass through the mask, while the remainder of the light may be blocked by the mask. The portion of the light that passes through the mask may be directed at the portion of the photo-curable material at which the spacer element is to be formed on the surface of the substrate. The light applied to the portion of the photo-curable material may cause the portion to be cured, while the remainder of the photo-curable material may remain uncured. The mask may be removed after the light is applied. The procedure may proceed to stage 1114.

Figure 14 illustrates an example substrate 1402 in accordance with stages 1108, 1110, and 1112. The substrate 1402 may include one or more of the features of the substrate 1002 (Fig. 10). The substrate 1402 may include a first pad 1404 and a second pad 1406 located at a surface 1408 of the substrate 1402.

A photo-curable material 1410 may be located on the surface 1408 of the substrate 1402. The photo-curable material 1410 may extend over an entirety of the surface 1408 of the substrate 1402. The photo-curable material 1410 may comprise polyimide, epoxy, benzocyclobutene, or some combination thereof. For example, the photo-curable material 1410 may include carbon, oxide, nitrogen, hydrogen, or some combination thereof.

A mask 1412 may be positioned over the photo-curable material 1410. In other embodiments, the mask 1412 may be positioned on the photo-curable material 1410. The mask 1412 may have an opening 1414 through which light may pass, while the mask 1412 does not allow light to pass through. The opening 1414 may be positioned over a first portion 1416 of the photo-curable material 1410 that corresponds to a position at which a spacer element (such as the spacer element 1018 (Fig. 10)) is to be formed on the surface 1408 of the substrate 1402.

A light source 1418 may be positioned over the mask 1412, such that the mask 1412 is located between the light source 1418 and the photo-curable material 1410. The light source 1418 may direct light at the mask 1412, wherein a portion of the light may pass through the opening 1414. The portion of light may contact the first portion 1416 and cause the first portion 1416 of the photo-curable material 1410 to be cured. A second portion 1420 of the photo-curable material 1410, which is not contacted by light from the light source 1418, may remain uncured.

In stage 1114, the uncured portion of the photo-curable material may be removed from the surface of the substrate. The uncured portion of the photo-curable material may be removed via a wet etch process, a dry etch process, a laser removal process, or some combination thereof. The cured portion of the photo-curable material that remains on the surface of the substrate may comprise a spacer element (such as the spacer element 1018). For example, the second portion 1420 of the photo-curable material 1410 may be removed and the first portion 1416 of the photo-curable material 1410 may comprise the spacer element in Figure 14. The procedure may proceed to stage 1116.

In stage 1116, a stencil may be positioned on the surface of the substrate. The stencil may include one or more supports that contact the surface of the substrate and support a body of the stencil off of the surface of the substrate.

The stencil may have a recess. The recess may be positioned with an open side of the recess abutting the surface of the substrate when the stencil is positioned on the surface of the substrate. Further, the recess may be aligned with the spacer material and/or spacer element, such that the spacer material and/or spacer element is located within the recess when the stencil is positioned on the substrate. The recess may have a depth greater than the height of the spacer material and/or the spacer element, such that the stencil does not contact the spacer material and/or the spacer element when positioned on the surface of the substrate.

The stencil may further have one or more openings. The openings may be positioned adjacent to pads of the substrate when the stencil is positioned on the surface of the substrate. Further, the openings may leave pads of the substrate exposed when the stencil is positioned on the surface of the substrate. The procedure may proceed to stage 1118.

In stage 1118, solder may be applied to the surface of the substrate. The solder 116 may comprise lead-based solder, lead-free solder, silver alloy solder, or some combination thereof. For example, the solder 116 may include tin, silver, copper, lead, hydrogen, oxygen, nitrogen, or some combination thereof. The solder may be applied to the surface while the stencil of stage 1116 is still positioned on the surface of the substrate. The solder may be applied to the portions of the surface of the substrate exposed by the openings of the stencil. Accordingly, the solder may be applied to the pads located adjacent to the openings. The stencil may be removed after the solder has been applied. The procedure may proceed to stage 1120.

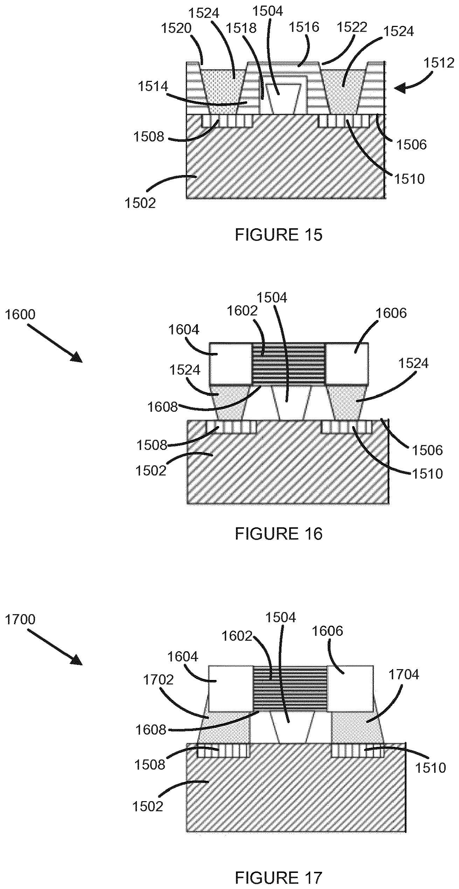

Figure 15 illustrates an example substrate 1502 in accordance with stages 1116 and 1118. The substrate 1502 may include one or more of the features of the substrate 1002 (Fig. 10). A spacer element 1504 may be located on a surface 1506 of the substrate 1502. The spacer element 1504 may have been formed on the surface via stage 1102, via stages 1104 and 1106, or via stages 1108, 1110, 1112, and 1114. The spacer element 1504 may comprise uncured spacer material (such as the spacer material applied in stages 1102 and 1106) or cured photo-curable material (such as the cured photo-curable material produced by stage 1112). The spacer element 1504 may be located on the surface 1506 of the substrate 1502 between a first pad 1508 and a second pad 1510 of the substrate 1502.

A stencil 1512 may be positioned on the surface 1506 of the substrate 1502. In particular, supports 1514 of the stencil 1512 may contact the surface 1506 of the substrate 1502 and support a body 1516 of the stencil 1512 off of the substrate 1502.

The stencil 1512 may have a recess 1518. The recess 1518 may be positioned with an open side of the recess 1518 abutting the surface 1506 of the substrate 1502. The recess 1518 may be aligned with the spacer element 1504 and the spacer element 1504 may extend with the recess 1518 when the stencil 1512 is positioned on the surface 1506 of the substrate 1502.

The stencil 1512 may have a first opening 1520 and a second opening 1522. The first opening 1520 may be positioned adjacent to the first pad 1508 and may leave a portion of the first pad 1508 exposed when the stencil 1512 is positioned on the surface 1506 of the substrate 1502. Further, the second opening 1522 may be positioned adjacent to the second pad 1510 and may leave a portion of the second pad 1510 exposed when the stencil 1512 is positioned on the surface 1506 of the substrate 1502.

Solder 1524 may be located on the first pad 1508, the first pad 1508 exposed by the first opening 1520, and the second pad 1510, the second pad 1510 exposed by the second opening 1522. In particular, the solder 1524 may be located within the first opening 1520 and the second opening 1522 and may fill, or at least partially fill, the first opening 1520 and the second opening 1522.

In stage 1120, a component may be positioned on the substrate. The component may include one or more of the features of the component 1004 (Fig. 10). The component may be positioned with pads of the component located on the solder formed on the pads of the substrate. Further, a surface of the component may be positioned on a side of the spacer element opposite to the substrate. The procedure may proceed to stage 1122.

Figure 16 illustrates an example substrate arrangement 1600 in accordance with stage 1120. The substrate arrangement 1600 may include the substrate 1502 with the spacer element 1504 located on the surface 1506 of the substrate 1502. Further, the solder 1524 may be located on the first pad 1508 and the second pad 1510.

The substrate arrangement 1600 may further include a component 1602. The component 1602 may include one or more of the features of the component 1004 (Fig. 10). The component 1602 may be positioned adjacent to the surface 1506 of the substrate 1502.

The component 1602 may include a first pad 1604 and a second pad 1606. The first pad 1604 of the component 1602 may be adjacent to the first pad 1508 of the substrate 1502 and may be in contact with the solder 1524 located on the first pad 1508. Further, the second pad 1606 of the component 1602 may be adjacent to the second pad 1510 of the substrate 1502 and may be in contact with the solder 1524 located on the second pad 1510. Further, a surface 1608 of the component 1602 that extends between the first pad 1604 and the second pad 1606 may abut the spacer element 1504 and may contact the spacer element 1504. In particular, the surface 1608 may contact the spacer element 1504 on an opposite side of the spacer element 1504 from the substrate 1502.

In stage 1122, a reflow process may be performed on the substrate arrangement formed in stage 1120. The reflow process may comprise heating the substrate arrangement to a temperature above the melting point of the solder. For example, in embodiments where the solder has a melting point of 225 degrees Celsius, the substrate arrangement may be heated to a temperature above 225 degrees Celsius to cause the solder to melt. In some embodiments, the solder may have a melting point between 170 degrees Celsius and 270 degrees Celsius, wherein the substrate arrangement may be heated above the melting point of the solder in the reflow process. After heating the substrate arrangement, the solder may be cooled, or may be allowed to cool, causing the solder to solidify.

Figure 17 illustrates a resultant substrate assembly 1700 in accordance with stage 1122. The substrate assembly 1700 may include the substrate 1502 and the component 1602. The component 1602 may be coupled to the substrate 1502 via a first solder joint 1702 and a second solder joint 1704. In particular, the first solder joint 1702 may couple the first pad 1604 of the component 1602 to the first pad 1508 of the substrate 1502. Further, the second solder joint 1704 may couple the second pad 1606 of the component 1602 to the second pad 1510 of the substrate 1502.

The first solder joint 1702 and the second solder joint 1704 may have been formed by performing the reflow process of stage 1122 on the substrate arrangement 1600 (Fig. 16). In particular, the reflow process may have caused the solder 1524 on the first pad 1508 to melt and solidify to form the first solder joint 1702. Further, the reflow process may have caused the solder 1524 on the second pad 1510 to melt and solidify to form the second solder joint 1704.

The surface 1608 of the component 1602 may be located on the spacer element 1504. In particular, the surface 1608 of the component 1602 may abut the spacer element 1504 on a side of the spacer element 1504 opposite from the substrate 1502. The spacer element 1504 may have maintained a distance between the component 1602 and the substrate 1502 during the reflow process of stage 1122.

While the spacer elements 118 (Fig. 1) and the spacer element 1018 (Fig. 10) are described in separate embodiments throughout this disclosure, it is to be understood that both the spacer elements 118 and the spacer element 1018 may be implemented in some of the same embodiments. In particular, solder joints (such as the solder joints 114 (Fig. 1)) may include spacer elements, in accordance with the spacer elements 118, and a spacer element, in accordance with the spacer element 1018, may be formed on a substrate (such as the substrate 102 (Fig. 1) and/or the substrate 1002 (Fig. 10)) in some embodiments.

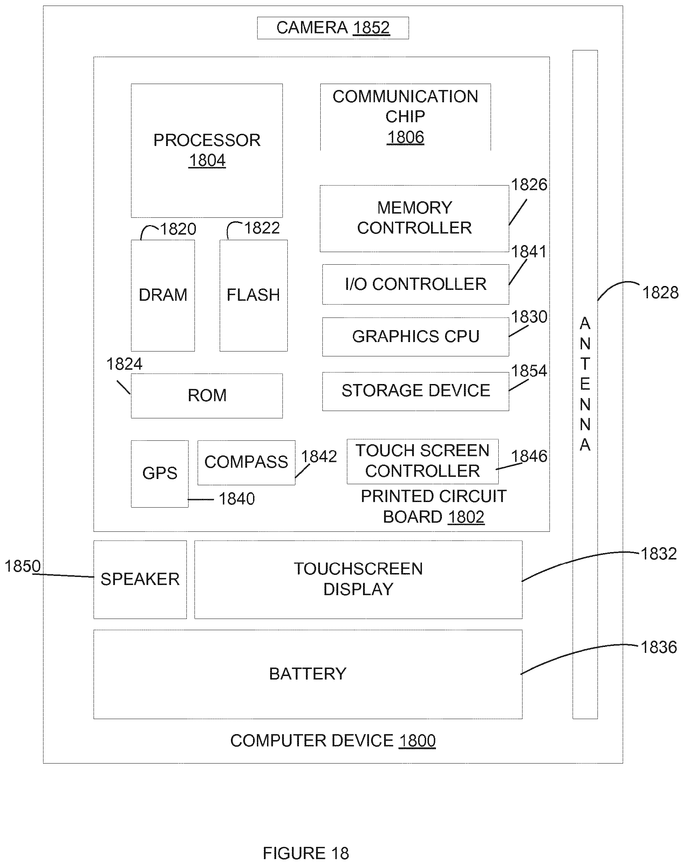

Figure 18 illustrates an example computer device 1800 that may employ the apparatuses and/or methods described herein (e.g., the substrate assembly 100, the spacer elements 118, the procedures 200, the substrate assembly 1000, the spacer element 1018, and/or the procedures 1100), in accordance with various embodiments. As shown, computer device 1800 may include a number of components, such as one or more processor(s) 1804 (one shown) and at least one communication chip 1806. In various embodiments, the one or more processor(s) 1804 each may include one or more processor cores. In various embodiments, the at least one communication chip 1806 may be physically and electrically coupled to the one or more processor(s) 1804. In further implementations, the communication chip 1806 may be part of the one or more processor(s) 1804. In various embodiments, computer device 1800 may include printed circuit board (PCB) 1802. For these embodiments, the one or more processor(s) 1804 and communication chip 1806 may be disposed thereon. In alternate embodiments, the various components may be coupled without the employment of PCB 1802.

Depending on its applications, computer device 1800 may include other components that may or may not be physically and electrically coupled to the PCB 1802. These other components include, but are not limited to, memory controller 1826, volatile memory (e.g., dynamic random access memory (DRAM) 1820), non-volatile memory such as read only memory (ROM) 1824, flash memory 1822, storage device 1854 (e.g., a hard-disk drive (HDD)), an input/output (I/O) controller 1841, a digital signal processor (not shown), a crypto processor (not shown), a graphics processor 1830, one or more antenna 1828, a display (not shown), a touch screen display 1832, a touch screen controller 1846, a battery 1836, an audio codec (not shown), a video codec (not shown), a global positioning system (GPS) device 1840, a compass 1842, an accelerometer (not shown), a gyroscope (not shown), a speaker 1850, a camera 1852, and a mass storage device (such as hard disk drive, a solid state drive, compact disk (CD), digital versatile disk (DVD)) (not shown), and so forth.

In some embodiments, the one or more processor(s) 1804, flash memory 1822, and/or storage device 1854 may include associated firmware (not shown) storing programming instructions configured to enable computer device 1800, in response to execution of the programming instructions by one or more processor(s) 1804, to practice all or selected aspects of the methods described herein. In various embodiments, these aspects may additionally or alternatively be implemented using hardware separate from the one or more processor(s) 1804, flash memory 1822, or storage device 1854.

In various embodiments, one or more components of the computer device 1800 may include the spacer elements 118 (Fig. 1) and/or the spacer element 1018 (Fig. 10). In particular, one or more of the components may include a substrate (such as the substrate 102 (Fig. 1) and/or the substrate 1002 (Fig. 10)), and may include spacer elements 118 in solder joints (such as the solder joints 114 (Fig. 1)) that couple the component to the substrate and/or spacer element 1018 located between the component and the substrate. For example, the one or more processors 1804 may have spacer elements 118 in solder joints that couple the one or more processors 1804 to the PCB 1802 and/or have spacer elements 1018 located between the one or more processors 1804 and the PCB 1802.

The communication chips 1806 may enable wired and/or wireless communications for the transfer of data to and from the computer device 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1806 may implement any of a number of wireless standards or protocols, including but not limited to IEEE 802.20, Long Term Evolution (LTE), LTE Advanced (LTE-A), General Packet Radio Service (GPRS), Evolution Data Optimized (Ev-DO), Evolved High Speed Packet Access (HSPA+), Evolved High Speed Downlink Packet Access (HSDPA+), Evolved High Speed Uplink Packet Access (HSUPA+), Global System for Mobile Communications (GSM), Enhanced Data rates for GSM Evolution (EDGE), Code Division Multiple Access (CDMA), Time Division Multiple Access (TDMA), Digital Enhanced Cordless Telecommunications (DECT), Worldwide Interoperability for Microwave Access (WiMAX), Bluetooth, derivatives thereof, as well as any other wireless protocols that are designated as 3G, 4G, 5G, and beyond. The computer device 1800 may include a plurality of communication chips 1806. For instance, a first communication chip 1806 may be dedicated to shorter range wireless communications such as Wi-Fi and Bluetooth, and a second communication chip 1806 may be dedicated to longer range wireless communications such as GPS, EDGE, GPRS, CDMA, WiMAX, LTE, Ev-DO, and others.

In various implementations, the computer device 1800 may be a laptop, a netbook, a notebook, an ultrabook, a smartphone, a computer tablet, a personal digital assistant (PDA), an ultra-mobile PC, a mobile phone, a desktop computer, a server, a printer, a scanner, a monitor, a set-top box, an entertainment control unit (e.g., a gaming console or automotive entertainment unit), a digital camera, an appliance, a portable music player, or a digital video recorder. In further implementations, the computer device 1800 may be any other electronic device that processes data.
Example 1 may include a substrate assembly, comprising a substrate, and a component coupled to the substrate via a solder joint, wherein the solder joint includes a spacer element and solder, the spacer element to maintain a distance between the substrate and the component.
Example 2 may include the substrate assembly of example 1, wherein the spacer element includes a spacer ball.
Example 3 may include the substrate assembly of example 1, wherein the spacer element includes a plurality of spacer balls.
Example 4 may include the substrate assembly of any of examples 1-3, wherein the spacer element includes copper or nickel, and wherein the solder includes tin.
Example 5 may include the substrate assembly of any of examples 1-3, wherein a melting temperature of the spacer element is higher than a melting temperature of the solder.
Example 6 may include the substrate assembly of any of examples 1-3, wherein a melting temperature of the spacer element is higher than 270 degrees Celsius.
Example 7 may include the substrate assembly of any of examples 1-3, wherein the distance is between ten microns and fifty microns.
Example 8 may include the substrate assembly of any of examples 1-3, wherein the solder joint is a first solder joint and the spacer element is a first spacer element, wherein the substrate includes a first pad and a second pad, wherein the component includes a first contact and a second contact, wherein the first solder joint is located between the first pad and the first contact, wherein a second solder joint couples the second pad and the second contact, and wherein the second solder joint includes a second spacer element and solder, the second spacer element to further maintain the distance between the substrate and the component.
Example 9 may include a method of mounting a component to a substrate, comprising positioning a stencil on the substrate, the stencil having an opening over a pad of the substrate, depositing a spacer element and solder within the opening, removing the stencil, positioning a contact of the component on the spacer element and the solder, and reflowing the solder to couple the contact and the pad, wherein the spacer element remains solid during the reflowing of the solder and maintains a distance between the component and the substrate.
Example 10 may include the method of example 9, wherein the solder includes a solder paste, and wherein the solder paste maintains positions of the spacer element and the solder when the stencil is removed.
Example 11 may include the method of examples 9 or 10, wherein depositing the spacer element and the solder includes depositing a mixture containing the spacer element and the solder within the opening.
Example 12 may include the method of examples 9 or 10, wherein depositing the spacer element and the solder includes depositing the spacer element within the opening, wherein the spacer element is deposited on the pad, and depositing the solder within the opening, wherein the solder is deposited on the spacer element.
Example 13 may include the method of examples 9 or 10, wherein depositing the spacer element and the solder includes depositing the solder within the opening, wherein the solder is deposited on the pad, and depositing the spacer element within the opening, wherein the spacer element is deposited on the solder.
Example 14 may include the method of example 13, wherein the spacer element includes a single spacer ball, and wherein a diameter of the spacer ball is between ten microns and fifty microns.
Example 15 may include the method of examples 9 or 10, wherein the spacer element includes a plurality of spacer balls.
Example 16 may include the method of examples 9 or 10, wherein the solder includes tin, and wherein the spacer element includes copper or nickel.
Example 17 may include the method of examples 9 or 10, wherein reflowing the solder includes applying heat to the spacer element and the solder.
Example 18 may include the method of example 17, wherein applying the heat includes heating the spacer element and the solder to a temperature of less than 270 degrees Celsius, wherein a melting temperature of the spacer element is greater than 270 degrees Celsius, and wherein a melting temperature of the solder is less than 270 degrees Celsius.
Example 19 may include a substrate assembly, comprising a substrate, a component coupled to the substrate, and a spacer element located between the substrate and the component, wherein the spacer element contacts a surface of the substrate and a surface of the component, and wherein the spacer element maintains a distance between the surface of the substrate and the surface of the component.
Example 20 may include the substrate assembly of example 19, wherein the substrate includes a first pad and a second pad, the component includes a first contact and a second contact, wherein a first electrical contact couples the first pad and the first contact, and a second electrical contact couples the second pad and the second contact, and the spacer element is located between the first pad and the second pad.
Example 21 may include the substrate assembly of examples 19 or 20, wherein the spacer element includes a polymer material.
Example 22 may include the substrate assembly of examples 19 or 20, wherein the spacer element includes an epoxy.
Example 23 may include the substrate assembly of examples 19 or 20, wherein the distance is between ten microns and fifty microns.
Example 24 may include a method of mounting a component to a substrate, comprising forming a spacer element on the substrate, positioning the component on the spacer element, applying solder between contacts of the component and pads of the substrate, and reflowing the solder, wherein the spacer element is to maintain a distance between the component and the substrate during reflowing of the solder.
Example 25 may include the method of example 24, wherein forming the spacer element includes dispensing the spacer element on the substrate, and curing the spacer element.
Example 26 may include the method of example 24, wherein forming the spacer element includes positioning a stencil on the substrate, the stencil having an opening for the spacer element, dispensing the spacer element within the opening, curing the spacer element, and removing the stencil.
Example 27 may include the method of example 24, wherein forming the spacer element includes applying material to a surface of the substrate, wherein the material is curable, positioning a mask over the material, the mask having an opening at a location where the spacer element is to be formed, directing light at the mask, wherein a portion of the light that passes through the opening causes a first portion of the material at the location to be cured, and wherein a second portion of the material remains uncured, removing the mask, and removing the second portion of the material, wherein the first portion of the material forms the spacer element.
Example 28 may include the method of any of examples 24-27, wherein applying the solder includes positioning a stencil on the substrate, wherein the stencil includes an opening for the solder, depositing the solder within the opening, and removing the stencil, wherein positioning the component on the spacer element occurs after the stencil is removed.
Example 29 may include the method of any of examples 24-27, wherein the spacer component includes a polymer material.
Example 30 may include the method of any of examples 24-27, wherein the spacer component includes an epoxy.
Example 31 may include the method of any of examples 24-27, wherein forming the spacer element includes forming the spacer element in a location between the pads of the substrate.
Example 32 may include the method of any of examples 24-27, wherein the distance is between ten microns and fifty microns.

It will be apparent to those skilled in the art that various modifications and variations can be made in the disclosed embodiments of the disclosed device and associated methods without departing from the spirit or scope of the disclosure. Thus, it is intended that the present disclosure covers the modifications and variations of the embodiments disclosed above provided that the modifications and variations come within the scope of any claims and their equivalents.

## Claims

1. A substrate assembly, comprising:
a substrate; and
a component coupled to the substrate via a solder joint, wherein the solder joint includes a spacer element and solder, the spacer element to maintain a distance between the substrate and the component.

2. The substrate assembly of claim 1, wherein the spacer element includes a spacer ball.

3. The substrate assembly of claim 1, wherein the spacer element includes a plurality of spacer balls.

4. The substrate assembly of any of claims 1-3, wherein the spacer element includes copper or nickel, and wherein the solder includes tin.

5. The substrate assembly of any of claims 1-3, wherein a melting temperature of the spacer element is higher than a melting temperature of the solder.

6. The substrate assembly of any of claims 1-3, wherein a melting temperature of the spacer element is higher than 270 degrees Celsius.

7. The substrate assembly of any of claims 1-3, wherein the solder joint is a first solder joint and the spacer element is a first spacer element, wherein the substrate includes a first pad and a second pad, wherein the component includes a first contact and a second contact, wherein the first solder joint is located between the first pad and the first contact, wherein a second solder joint couples the second pad and the second contact, and wherein the second solder joint includes a second spacer element and solder, the second spacer element to further maintain the distance between the substrate and the component.

8. A method of mounting a component to a substrate, comprising:
positioning a stencil on the substrate, the stencil having an opening over a pad of the substrate;
depositing a spacer element and solder within the opening;
removing the stencil;
positioning a contact of the component on the spacer element and the solder; and
reflowing the solder to couple the contact and the pad, wherein the spacer element remains solid during the reflowing of the solder and maintains a distance between the component and the substrate.

9. The method of claim 8, wherein depositing the spacer element and the solder includes at least one of:
depositing a mixture containing the spacer element and the solder within the opening;
depositing the spacer element within the opening, wherein the spacer element is deposited on the pad;
depositing the solder within the opening, wherein the solder is deposited on the spacer element;
depositing the solder within the opening, wherein the solder is deposited on the pad; and/or
depositing the spacer element within the opening, wherein the spacer element is deposited on the solder.

10. The method of claims 8 or 9, wherein the spacer element includes at least one of:
a single spacer ball, wherein a diameter of the spacer ball is between ten microns and fifty microns; and/or
a plurality of spacer balls.

11. A substrate assembly, comprising:
a substrate;
a component coupled to the substrate; and
a spacer element located between the substrate and the component, wherein the spacer element contacts a surface of the substrate and a surface of the component, and wherein the spacer element maintains a distance between the surface of the substrate and the surface of the component.

12. The substrate assembly of claim 11, wherein:
the substrate includes a first pad and a second pad;
the component includes a first contact and a second contact, wherein a first electrical contact couples the first pad and the first contact, and a second electrical contact couples the second pad and the second contact; and
the spacer element is located between the first pad and the second pad.

13. The substrate assembly of claims 11 or 12, wherein the spacer element includes a polymer material.

14. A method of mounting a component to a substrate, comprising:
forming a spacer element on the substrate;
positioning the component on the spacer element;
applying solder between contacts of the component and pads of the substrate; and
reflowing the solder, wherein the spacer element is to maintain a distance between the component and the substrate during reflowing of the solder.

15. The method of claim 14, wherein forming the spacer element includes at least one of:
dispensing the spacer element on the substrate;
curing the spacer element;
positioning a stencil on the substrate, the stencil having an opening for the spacer element;
dispensing the spacer element within the opening;
curing the spacer element;
removing the stencil;
applying material to a surface of the substrate, wherein the material is curable;
positioning a mask over the material, the mask having an opening at a location where the spacer element is to be formed;
directing light at the mask, wherein a portion of the light that passes through the opening causes a first portion of the material at the location to be cured, and wherein a second portion of the material remains uncured;
removing the mask; and/or
removing the second portion of the material, wherein the first portion of the material forms the spacer element.
